# FASCICULE DE BREVET EUROPEEN

(11) **EP 3 092 628 B1**
(45) Date de publication et mention de la délivrance du brevet: **08.05.2019**
(21) Numéro de dépôt: 15702515.6
(22) Date de dépôt: 05.01.2015
(51) Int. Cl.: G07C 9/00, G06K 7/00, G07F 7/08, H02B 1/26, H05K 5/00

(54) **LECTEUR DE CONTROLE D'ACCES ET MODULE COMPLEMENTAIRE DE CONTROLE**
ZUGRIFFSSTEUERUNGSLESEGERÄT UND ZUGEHÖRIGES STEUERMODUL
ACCESS CONTROL READER AND COMPLEMENTARY CONTROL MODULE

(30) Priorité: 07.01.2014 FR 1450088
(43) Date de publication de la demande: 16.11.2016
(73) Titulaire: Systemes Et Technologies Identification (STID), 13850 Greasque (FR)
(72) Inventeur: DUPART, Vincent, F-83470 Saint-Maximin-la-Sainte-Beaume (FR); SILVE, Jérôme, F-13790 Rousset (FR); POITRAT, Sylvain, F-13850 Greasque (FR)
(74) Mandataire: Chevalier, Renaud Philippe
(86) Numéro de dépôt international: PCT/FR2015/050005
(87) Numéro de publication internationale: WO 2015/104486

(56) Documents cités:
- EP-A1- 2 487 351
- EP-A2- 0 353 443
- WO-A1-96/27858
- WO-A1-98/50876
- US-A1- 2005 204 167

## Description

La présente invention se rapporte à un lecteur de contrôle d'accès, notamment de contrôle par radio-identification (RFID), contrôle clavier ou contrôle écran. Elle se rapporte aussi à un système de contrôle d'accès intégrant un lecteur de contrôle d'accès et un module complémentaire de contrôle.

Les lecteurs de contrôle d'accès, ou lecteurs d'identification sécurisée, sont généralement équipés d'une ou plusieurs fonctionnalités de contrôle pré-intégrées dans un boîtier, comme connu notamment de la demande de brevet FR 2 988 871.

A partir d'un lecteur standard, l'ajout d'une nouvelle fonctionnalité, telle qu'une fonction de contrôle biométrique, n'est pas possible. Il est nécessaire de désinstaller le lecteur standard pour installer un nouveau lecteur qui intègre la nouvelle fonctionnalité désirée. Autrement dit, l'ajout d'une nouvelle fonctionnalité est complexe et coûteuse car nécessitant une désinstallation complète de l'ancien lecteur et une réinstallation complète du nouveau lecteur.

Il est également connu, du document WO 96/27858, d'employer un lecteur de contrôle d'accès comprenant un boitier pourvu d'un socle fermé par une façade, où la façade est pourvue d'une ouverture haute pour recevoir un clavier ou un écran qui est connecté à une carte électronique. La façade est également pourvue d'une ouverture centrale par laquelle une unité de lecture de cartes peut être enfichée dans le boitier. Une fois insérée, cette unité de lecture de cartes se raccorde à la carte électronique au moyen d'un connecteur qui se branche sur un connecteur complémentaire. Ainsi, l'unité de lecture de cartes est placée à l'intérieur du boîtier du lecteur, ce qui présente des inconvénients car le boîtier du lecteur doit être suffisamment grand pour recevoir l'unité de lecture de cartes, et ce même si cette unité de lecture de cartes n'est pas présente. En outre, en l'absence de cette unité de lecture de cartes, le boîtier du lecteur présente des risques d'intrusion au niveau de l'ouverture centrale de sa façade.

La présente invention a pour but de résoudre ces inconvénients en proposant un lecteur de contrôle d'accès qui permette d'ajouter une nouvelle fonctionnalité à un lecteur, sans avoir à le remplacer par un autre lecteur.

A cet effet, elle propose un lecteur de contrôle d'accès selon la revendication 1.

Ainsi, ce lecteur permet de recevoir une nouvelle fonctionnalité présente sur un module complémentaire, en étant conformé pour permettre la fixation du module sur le lecteur et la connexion du module à la carte électronique, ladite carte électronique étant adaptée pour une intégration directe du module. En effet, la carte électronique est pré-paramétrée pour accueillir et piloter un module complémentaire, et ainsi il n'est plus nécessaire de déposer un lecteur déjà en place ni de modifier l'installation existante (câblage, trous de fixation, etc.). Grâce à l'invention, il suffit juste de connecter le module complémentaire à la carte électronique, qui reconnaîtra et gérera automatiquement ce module, et de fixer le module sur le boîtier du lecteur.

Par ailleurs, le module complémentaire étant fixé sur l'extérieur du boîtier du lecteur, le lecteur est dimensionné pour être utilisable seul, et aucun surdimensionnement du boîtier du lecteur n'est nécessaire pour accueillir le module complémentaire. Autrement dit, le boîtier du lecteur comporte plus spécifiquement des moyens de fixation du module complémentaire de contrôle d'accès sur l'extérieur du boîtier du lecteur, et notamment sur le dessous du boîtier du lecteur.

Selon une caractéristique, les moyens de fixation comportent :
- des orifices de fixation prévus sur le socle et sur la ou chaque façade pour le passage de vis de fixation ; et
- des moyens de maintien provisoire et d'indexage du module sur le boîtier.

Ainsi, les orifices de fixation qui servent à la fixation de la façade sur le socle, serviront également à la fixation du module sur le boîtier. Les moyens de maintien provisoire et d'indexage serviront quant à eux à indexer en position le module sur le lecteur (pour centrer correctement le module vis-à-vis des orifices de fixation et des moyens de passage du câble de connexion) et à maintenir provisoirement le module en place, le temps de visser les vis, de préférence du type vis inviolable.

Selon une autre caractéristique, les moyens de maintien provisoire et d'indexage comprennent :
- un rebord inférieur du socle faisant saillie de la paroi principale et
- un rebord inférieur de la ou chaque façade faisant saillie de la paroi frontale où, dans la configuration fermée du boîtier, le rebord inférieur de la façade vient dans l'alignement du rebord inférieur du socle avec un écartement donné entre les deux rebords inférieurs pour former une fente inférieure sous le boîtier, afin de permettre le passage et l'indexage de pattes de maintien du module.

Ainsi, en l'absence de module, le boîtier présente une simple fente inférieure qui, le cas échéant, va permettre de réceptionner des pattes de maintien pour l'indexage et le maintien provisoire du module sur le boîtier.

Avantageusement, les moyens de passage comprennent une ligne de faiblesse ménagée sur le rebord inférieur du socle pour former une amorce de rupture d'une encoche fusible.

Une telle encoche fusible permet de garantir l'étanchéité du boîtier en l'absence d'un module, tout en permettant la formation d'un passage pour le câble de connexion après rupture du rebord inférieur selon la ligne de faiblesse.

Dans une réalisation particulière, la ou chaque façade comporte en outre un plateau inférieur en saillie de la paroi frontale et disposé au-dessus du rebord inférieur où, dans la configuration fermée du boîtier, ledit plateau vient en appui contre le rebord inférieur du socle, et les moyens de passage comprennent également une encoche ménagée dans ledit plateau et qui est, dans la configuration fermée du boîtier, positionnée en face de l'encoche fusible prévue sur le rebord inférieur du socle.

Ce plateau inférieur renforce l'étanchéité du boîtier en l'absence du module, tout en permettant le passage pour le câble de connexion grâce à son encoche placée en face de l'encoche fusible.

Dans un mode de réalisation particulier, le rebord inférieur du socle est incliné vers le bas par rapport à la paroi principale selon un angle non droit et, dans la configuration fermée du boîtier, le plateau de la façade est orthogonal à la paroi principale du socle.

Selon une possibilité de l'invention, le boîtier du lecteur comprend au moins une autre façade interchangeable avec la façade du boîtier, ladite autre façade étant équipée d'un dispositif secondaire de contrôle d'accès, notamment du type contrôle clavier ou contrôle écran, et où la mémoire de la carte électronique est chargée d'un troisième algorithme de pilotage pour piloter ledit dispositif secondaire de contrôle d'accès afin que le contrôleur pilote ledit dispositif secondaire de contrôle d'accès une fois que l'autre façade a remplacée la façade sur le boîtier et que le dispositif secondaire de contrôle d'accès est connecté à la carte électronique.

Ainsi, le lecteur offre une modularité avantageuse car il permet d'obtenir une nouvelle fonctionnalité de contrôle d'accès (par exemple par clavier ou caméra), tout simplement en remplaçant la façade par une autre façade et de changer les câblages, sans avoir à intervenir sur la carte électronique. En effet, la carte électronique est déjà configurée pour permettre le pilotage de cette nouvelle fonctionnalité (en l'occurrence le pilotage du dispositif secondaire de contrôle d'accès intégrée à l'autre façade). Ainsi, la modularité du lecteur se traduit par la possibilité de rajouter un module complémentaire et par la possibilité de remplacer une façade par une autre.

Avantageusement, la ou chaque façade comporte des moyens d'encliquetage adaptés pour une fixation par encliquetage de la carte électronique.

De tels moyens d'encliquetage permettent un retrait aisé de la carte électronique, en particulier en cas de changement de façade comme décrit ci-dessus. Ainsi, si on remplace une façade (par exemple une façade entièrement pleine adaptée pour former une surface de lecture d'un badge RFID) par une autre façade intégrant un dispositif secondaire de contrôle d'accès (par exemple un clavier ou un écran), il suffit de déclipser la carte électronique de la façade pour la reclipser sur l'autre façade ; la carte électronique intégrant comme déjà expliqué en mémoire tous les algorithmes de pilotage permettant de gérer toutes les fonctionnalités souhaités.

Ces moyens d'encliquetage permettent donc une insertion facile de la carte électronique, un maintien mécanique en force, nécessaire à la robustesse du lecteur, et une extraction aisée de la carte électronique dans le but de changer la façade pour faire évoluer le lecteur vers de nouvelles fonctionnalités (par exemple clavier, écran, caméra, ...), le tout sans outil annexe.

Selon une autre possibilité de l'invention, les moyens d'encliquetage comprennent des butées d'appui pour la carte électronique et des pattes élastiquement déformables équipées respectivement de dents d'encliquetage, avec éventuellement des crochets fixes de retenue, et faisant par exemple tous saillie de la paroi frontale de la ou chaque façade.

L'invention se rapporte également à un système de contrôle d'accès selon la revendication 10.

Ainsi, ce module complémentaire permet d'apporter une nouvelle fonctionnalité à un lecteur déjà en place, comme expliqué précédemment, en raccordant le câble de connexion à la carte électronique et en fixant le boîtier du module sur le boîtier du lecteur, et plus spécifiquement sur l'extérieur du boîtier du lecteur ; sans avoir à reconfigurer le contrôleur du lecteur.

Conformément à une caractéristique avantageuse, les moyens complémentaires de fixation comprennent :
- des orifices ménagés sur le module et adaptés pour coïncider avec les orifices de fixation du lecteur, afin de permettre la fixation conjuguée du module sur le boîtier et de la façade sur le socle avec les mêmes vis de fixation ; et
- des moyens complémentaires de maintien provisoire et d'indexage conformés pour coopérer avec les moyens de maintien provisoire et d'indexage du lecteur.

Selon une autre caractéristique, les moyens complémentaires de maintien provisoire et d'indexage comportent des pattes de maintien provisoire adaptées pour s'engager à travers la fente inférieure prévue sous le boîtier du lecteur et venir en appui sur le rebord inférieur de la façade.

D'autres caractéristiques et avantages de la présente invention apparaîtront à la lecture de la description détaillée ci-après, d'un exemple de mise en oeuvre non limitatif, faite en référence aux figures annexées dans lesquelles :
- la figure 1 est une vue en perspective de face d'un premier exemple de lecteur conforme à l'invention qui comporte un boîtier pourvu d'une façade avant pleine pour uniquement une lecture par radio-identification ;
- la figure 2 est une vue en perspective de dos d'une façade du boîtier du lecteur de la figure 1 ;
- la figure 3 est une vue de dessous de la façade de la figure 2 ;
- les figures 4 à 6 sont des vues en perspective de dos de la façade de la figure 2, sans la carte électronique du lecteur (figure 4), pendant le montage de la carte électronique sur la façade (figure 5), et avec la carte électronique montée sur la façade (figure 6) ;
- la figure 7 est une vue en coupe transversale du boîtier du lecteur de la figure 1 ;
- la figure 8 est une vue de dessous du boîtier du lecteur de la figure 1 ;
- la figure 9 est une vue en perspective de face d'un socle du boîtier du lecteur de la figure 1 ;
- les figures 10 et 11 sont des vues en perspective de face (figure 10) et de dos (figure 11) du boîtier d'un exemple de module complémentaire de contrôle biométrique conforme à l'invention ;
- la figure 12 est une vue en perspective de face du module des figures 10 et 11, sans son couvercle de fermeture et avec son câble de connexion ;
- la figure 13 est une vue en perspective de face d'un premier système de contrôle d'accès conforme à l'invention composé de l'assemblage du module des figures 10 et 11 sur le premier lecteur de la figure 1 ;
- la figure 14 est une vue en perspective de face d'un deuxième exemple de lecteur conforme à l'invention qui comporte un boîtier pourvu d'une façade avant intégrant un clavier ;
- la figure 15 est une vue en perspective de face d'un deuxième système de contrôle d'accès conforme à l'invention composé de l'assemblage du module des figures 10 et 11 sur le deuxième lecteur de la figure 14 ;
- la figure 16 est une vue en perspective de face d'un troisième exemple de lecteur conforme à l'invention qui comporte un boîtier pourvu d'une façade avant intégrant un écran ;
- la figure 17 est une vue en perspective de face d'un troisième système de contrôle d'accès conforme à l'invention composé de l'assemblage du module des figures 10 et 11 sur le troisième lecteur de la figure 16.

En référence aux figures, un lecteur L conforme à l'invention comporte un boîtier 1 composé de deux parties : un socle 2 prévu pour une fixation sur un support (non illustré) vertical, généralement un mur ou une cloison, et une façade 3 montée sur le socle 2. Une fois la façade 3 montée sur le socle 2, le boîtier 1 délimite intérieurement un espace clos à l'intérieur duquel est disposée une carte électronique 9 intégrant au moins un contrôleur (notamment du type microprocesseur), une mémoire et un dispositif principal de contrôle d'accès (non illustrés).

Le dispositif principal de contrôle d'accès, intégré à la carte électronique 9, est composé d'un lecteur de radio-identification (RFID) pour la lecture de badges munis de puces RFID. Le contrôleur pilote ce dispositif principal de contrôle d'accès par radio-identification en mettant en oeuvre un premier algorithme de pilotage chargé dans la mémoire de la carte électronique 9.

Le socle 2 comporte une paroi dite principale 20 plane qui vient se plaquer contre le support afin d'y être fixée. Cette paroi plane 20 présente une ouverture centrale 210 pour le passage de câbles (non illustrés) et des orifices 211, de préférence oblongs, pour le passage de vis de fixation (non illustrées) du socle 2 sur le support. La paroi principale 20 présente une face interne en regard de la façade 3 une fois le boîtier 1 monté, et une face externe opposée à la face interne, où ladite face externe est plaquée contre le support une fois le socle 2 fixé sur le support.

Le socle 2 comporte également deux rebords latéraux 24 en vis-à-vis, qui font saillie de la face interne de la paroi principale 20 et qui sont perpendiculaires à la paroi principale 20. Le socle 2 comporte aussi un rebord inférieur 25 également en saillie de la face interne de la paroi principale 20, et qui est prévu sur une partie inférieure du socle 2, qui sera située en bas une fois le boîtier 1 en situation, ce rebord inférieur 25 reliant les deux rebords latéraux 24.

Une ligne de faiblesse est ménagée sur le rebord inférieur 25 du socle 2 pour former une amorce de rupture d'une encoche fusible 26. Cette ligne de faiblesse est réalisée sous la forme d'une réduction de l'épaisseur du rebord inférieur 25, sur le pourtour de l'encoche fusible 26.

Le socle 2 présente également deux orifices (non visibles) ménagés en partie inférieure du socle 2, pour le passage de vis de fixation de la façade 3 sur le socle 2. Pour plus de détail concernant la fixation de la façade 3 sur le socle 2, nous nous reporterons utilement à la demande de brevet EP 3 092 596 A (SYSTEMES ET TECHNOLOGIES IDENTIFICATION), 16 novembre 2016, déposée par la Demanderesse le même jour que la présente demande de brevet.

Trois exemples de lecteur L sont décrits ci-après, étant précisé que seule la façade 3 change entre les différents lecteurs L, le socle 2 et la carte électronique 9 étant conservés pour ces différents lecteurs L.

Dans tous les cas, la façade 3 comporte une paroi principale 30 frontale et bombée qui fait face à la paroi principale 20 du socle 2 en situation.

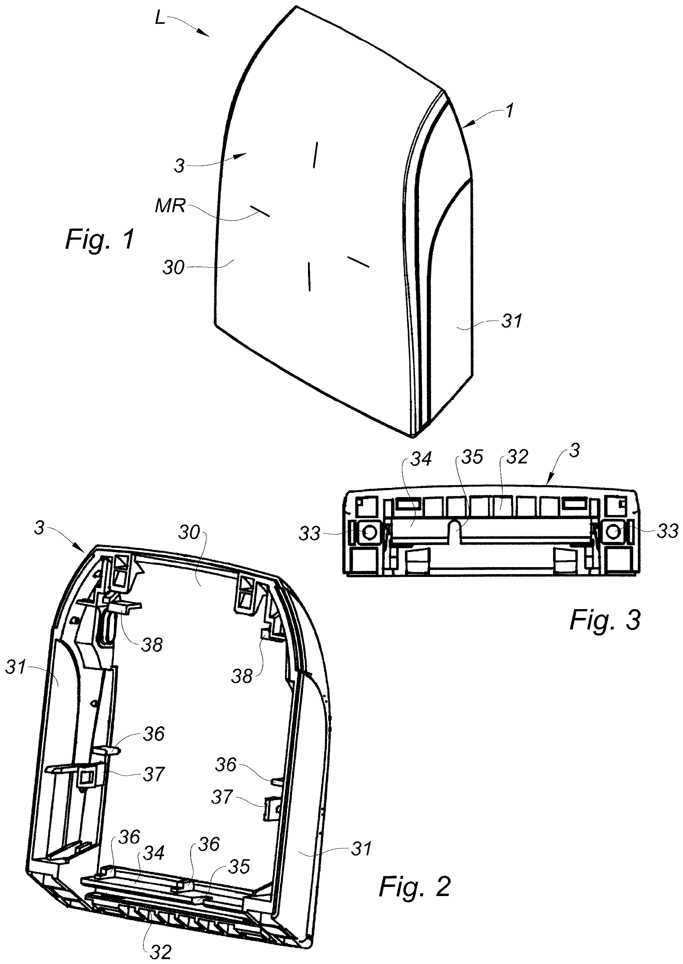

Les figures 1 à 8 et 13 illustrent un premier lecteur L intégrant une première façade 3 qui présente une paroi principale 30 qui est pleine, avantageusement pourvue d'une mire MR de localisation de la zone de lecture des badges de radio-identification. La mire MR est par exemple composée de quatre traits non jointifs définissant une croix. Ainsi, ce premier lecteur L est uniquement conçu pour un contrôle par radio-identification au moyen du lecteur de radio-identification intégré à la carte électronique 9.

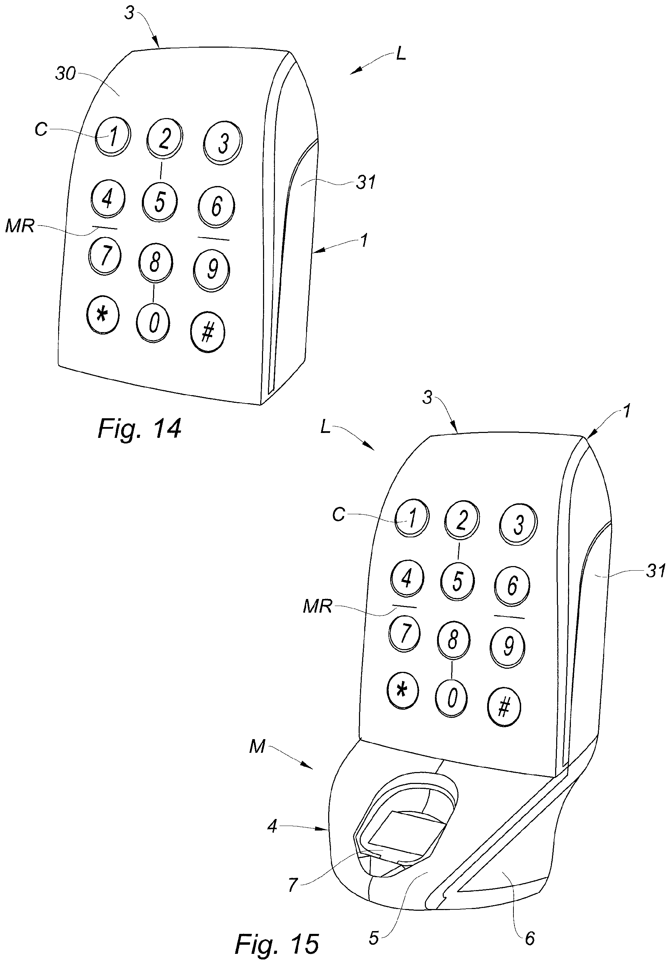

Les figures 14 et 15 illustrent un deuxième lecteur L intégrant une deuxième façade 3 qui présente une paroi principale 30 dans laquelle est incorporé un clavier C composé de plusieurs touches permettant la saisie d'un code d'identification. Ainsi, ce deuxième lecteur L est conçu pour un contrôle par radio-identification (toujours au moyen du lecteur de radio-identification intégré à la carte électronique 9) et également pour un contrôle par clavier. La mire MR est avantageusement présente sur cette paroi principale 30, par exemple entre les touches du clavier C.

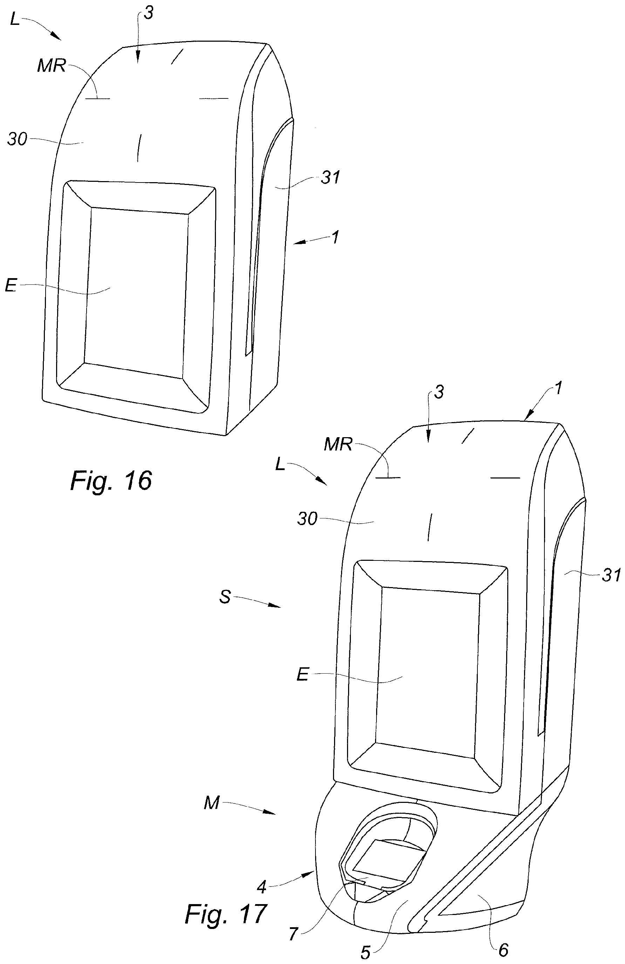

Les figures 16 et 17 illustrent un troisième lecteur L intégrant une troisième façade 3 qui présente une paroi principale 30 dans laquelle est incorporé un écran E pour un contrôle par écran ; cet écran E étant de préférence un écran tactile pour permettre notamment la saisie d'un code d'identification. Ainsi, ce troisième lecteur L est conçu pour un contrôle par radio-identification (toujours au moyen du lecteur de radio-identification intégré à la carte électronique 9) et également pour un contrôle par écran. La mire MR est avantageusement présente sur cette paroi principale 30, par exemple au-dessus de l'écran E.

Les trois façades 3 décrites sont interchangeables, assurant ainsi une modularité du lecteur L. Pour simplifier cette modularité, la mémoire de la carte électronique 9 est chargée d'un algorithme de pilotage pour piloter le clavier C et d'un algorithme de pilotage pour piloter l'écran E, de sorte que le contrôleur de la carte électronique 9 peut piloter le clavier C et l'écran E une fois que la nouvelle façade 3 concernée est en place sur le socle 2 et une fois que le clavier C ou l'écran E est connecté à la carte électronique 9.

Pour permettre cette interchangeabilité des façades 3, ces dernières sont toutes conformées pour mécaniquement coopérer avec le même socle 2 qui lui reste en place sur le support.

Pour chaque façade 3, la paroi principale 30 est prolongée, d'une part, sur les côtés par des rebords latéraux 31 qui recouvrent les rebords latéraux 24 du socle 2 en situation et, d'autre part, sur le dessous par un rebord inférieur 32 qui vient dans l'alignement du rebord inférieur 25 du socle 2 en situation, avec un écartement EC donné entre les deux rebords inférieurs 25, 32 pour former une fente inférieure sous le boîtier 1.

Chaque façade 3 présente deux orifices 33 ménagés en partie inférieure et prévus pour être dans l'alignement des deux orifices du socle 2 pour le passage de vis de fixation de la façade 3 sur le socle 2.

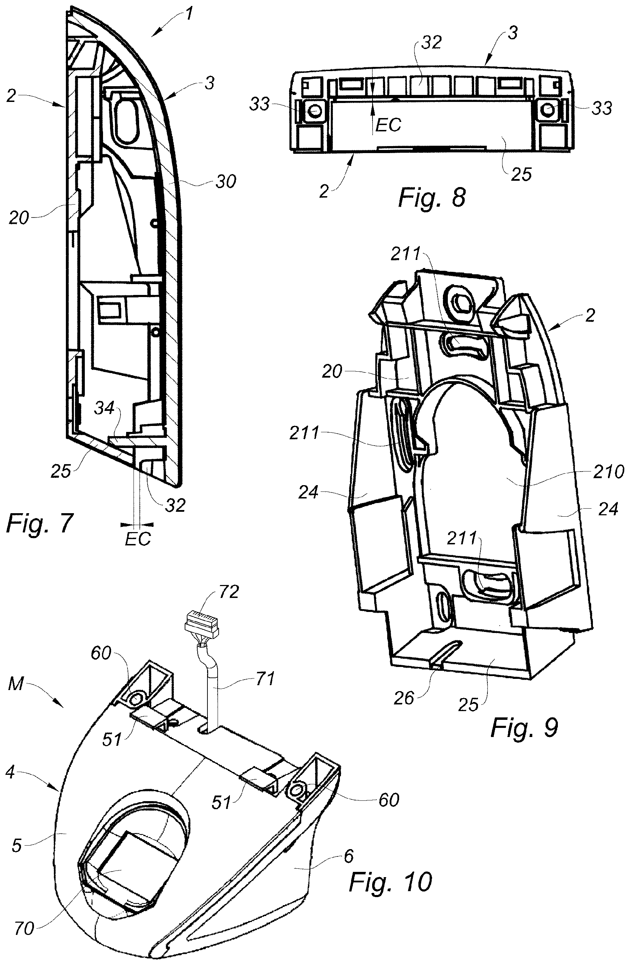

Chaque façade 3 comporte en outre un plateau inférieur 34 en saillie de la paroi frontale 30 (vers l'intérieur du boîtier 1) et disposé au-dessus du rebord inférieur 32. Comme visible sur la figure 7, dans la configuration fermée du boîtier 1, le rebord inférieur 25 du socle est incliné vers le bas par rapport à la paroi principale 20 selon un angle non droit, le plateau inférieur 34 est orthogonal à la paroi principale 20 du socle 2 et vient en appui contre le rebord inférieur 25 du socle 2 pour limiter l'accès et offrir une étanchéité au boîtier.

Une encoche 35 est ménagée dans le plateau inférieur 34 et, dans la configuration fermée du boîtier 1, cette encoche 35 est positionnée en face de l'encoche fusible 26 prévue sur le rebord inférieur 25 du socle 2.

En outre, chaque façade 3 comporte des moyens de fixation de la carte électronique 9 ; cette carte électronique 9 étant ainsi fixée sur la façade 3. Lors d'un changement de façade 3, pour faciliter le retrait de la carte électronique 9 d'une façade 3 et faciliter la fixation de la carte électronique 9 sur la nouvelle façade 3, ces moyens de fixation sont constitués de moyens d'encliquetage adaptés pour une fixation par encliquetage de la carte électronique 9.
- Ces moyens d'encliquetage comportent plusieurs éléments d'encliquetage qui font saillie de la face interne de la paroi principale 30, dont :des butées d'appui 36 sur lesquelles la carte électronique 9 vient en appui ;
- des pattes élastiquement déformables 37 équipées respectivement de dents d'encliquetage, conçues pour s'écarter lors de l'introduction de la carte 9 et revenir en position pour bloquer la carte 9, ces pattes élastiquement déformables 37 étant notamment disposées sur les côtés de la façade 3 ; et
- des crochets 38 fixes de retenue, ces crochets 38 étant notamment disposés en partie supérieure de la façade 3.

En variante, les moyens d'encliquetage peuvent comprendre uniquement des pattes élastiquement déformables équipées respectivement de dents d'encliquetage, avec oui sans les butées d'appui.

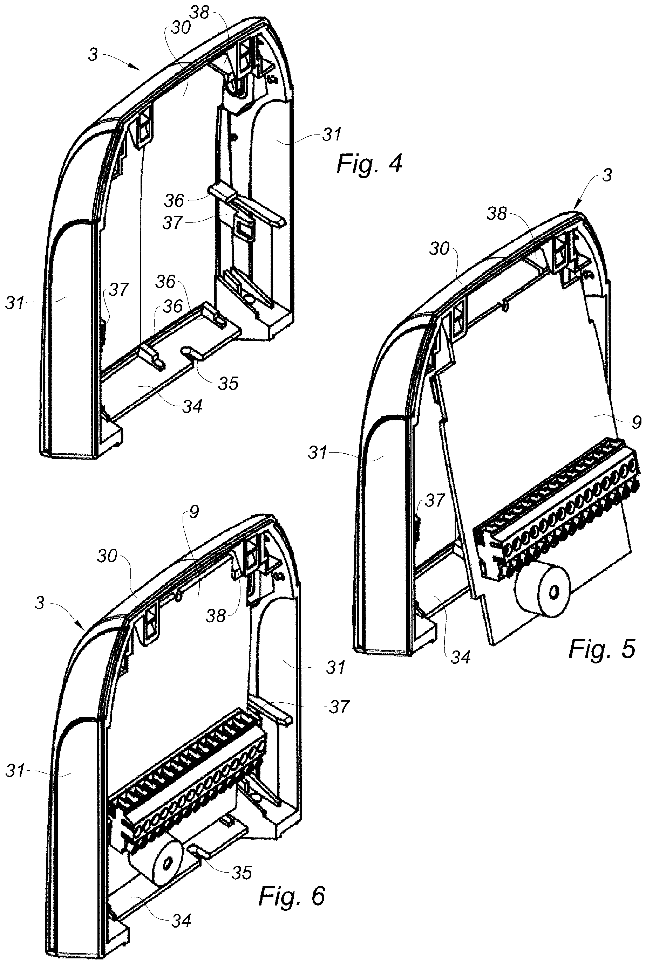

En référence aux figures 4 à 6, pour fixer la carte 9 sur la façade 3, il suffit, sans outillage spécifique, de placer le haut de la carte 9 sous les crochets 38, puis d'abaisser le bas de la carte 9 jusqu'à venir bloquer celle-ci sous les dents des pattes élastiquement déformables 37 par déformation de celles-ci, tout en venant mettre en appui la carte 9 contre les butées d'appui 36.

La modularité de l'invention ne se limite pas aux possibles changements de façades 3, mais se traduit également par la possibilité d'ajouter un module M complémentaire de contrôle d'accès qui peut être greffé sur le lecteur L.

En référence aux figures 10 à 12, le module M comporte un boîtier 4 composé d'un capot 5 monté sur une embase 6, et un dispositif complémentaire de contrôle d'accès 7 disposé à l'intérieur du boîtier 4. Une fois le capot 5 monté sur l'embase 6, le boîtier 4 délimite intérieurement un espace clos à l'intérieur duquel est disposé le dispositif complémentaire de contrôle d'accès 5.

Le dispositif complémentaire de contrôle d'accès 7 est du type contrôle biométrique et présente une surface de lecture biométrique 70, notamment pour l'identification d'une empreinte digitale. Il est cependant bien entendu que tout autre type de contrôle biométrique peut être envisagé, comme un contrôle par reconnaissance de l'iris, reconnaissance faciale, reconnaissance de l'empreinte palmaire, etc. Il est également envisageable que le dispositif complémentaire de contrôle d'accès 7 soit d'un autre type que biométrique, comme par exemple du type contrôle clavier ou contrôle écran.

Dans tous les cas, le dispositif complémentaire de contrôle d'accès 7 présente une interface de lecture sur le capot 5 du boîtier 4, comme par exemple la surface de lecture biométrique 70 précitée, un clavier ou un écran.

Le dispositif complémentaire de contrôle d'accès 7 comporte également un câble de connexion 71 sortant du boîtier 4 à travers une ouverture 50 ménagée sur le haut du capot 5.

Ce câble de connexion 71 est prévu pour passer à travers l'encoche fusible 26 (après rupture de la ligne de faiblesse) et à travers l'encoche 35 pour venir se connecter sur la carte électronique 9. A cet effet, le câble de connexion 71 présente une extrémité libre pourvue d'un connecteur complémentaire 72 conformé pour être branché sur un connecteur adéquat (non illustré) intégré à la carte 9 et relié au contrôleur.

Pour permettre la prise en charge de ce module M par le contrôleur de la carte 9, et plus spécifiquement permettre le pilotage du dispositif complémentaire de contrôle d'accès 7, la mémoire de la carte électronique 9 est chargée d'un algorithme de pilotage pour piloter ce dispositif complémentaire de contrôle d'accès 7, de sorte que le contrôleur de la carte électronique 9 peut piloter ce dispositif complémentaire de contrôle d'accès 7 une fois que le module M est fixé sur le lecteur L et une fois que le dispositif complémentaire de contrôle d'accès 7 est connecté à la carte électronique 9 via le câble de connexion 71.

Le boîtier 4 du module M est conformé pour être fixé sur le boîtier 1 du lecteur L, et plus précisément sous le boîtier 1 du lecteur L.

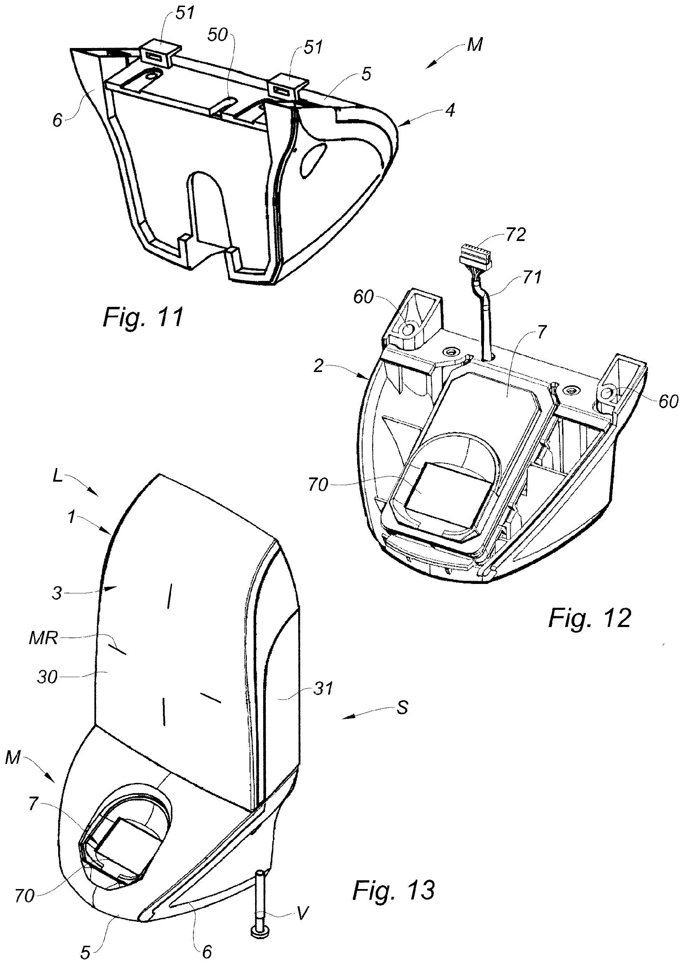

Pour cette fixation du boîtier 4 du module M sur l'extérieur du boîtier 1 du lecteur L, le boîtier 4 présente des orifices 60 prévus sur l'embase 6, ces orifices 60 étant prévus pour venir dans l'alignements des orifices 33 du socle 2 et de la façade 3 du boîtier 1, afin de permettre le passage de vis de fixation V (visibles sur la figure 13) qui assurent la fixation du module M sur le boîtier 1 du lecteur L. Ainsi, les orifices prévus sur le socle 2 et sur la façade 3 du boîtier 1, qui servent initialement à la fixation de la façade 3 sur le socle 2, sont exploités pour permettre la fixation combinée de la façade 3 sur le socle 2 et du module M sur le boîtier 1.

Avant d'opérer la fixation par vissage du module M sur le boîtier 1, il est intéressant d'assurer un maintien provisoire et un indexage du module M sur le boîtier 1. Pour ce faire, le boîtier 4 présente des pattes 51 prévues sur le capot 5, qui font saillie sur le haut du boîtier 4.

Ces pattes 51 de maintien provisoire sont en forme de crochet et sont adaptées pour s'engager à travers la fente inférieure d'écartement EC prévue sous le boîtier 1 entre les deux rebords inférieurs 25, 32, et pour venir en appui sur le rebord inférieur 32 de la façade 3.

Le montage du module M sur le lecteur L se fait comme suit :
- on retire les vis de fixation de la façade 3 sur le socle 2 ;
- on retire la façade 3 ;
- on assure le centrage et le maintien provisoire du module M sur la façade 3, en plaçant les pattes 51 en appui sur le rebord inférieur 32 de la façade 3 et, tout en prenant soin de faire passer le câble de connexion 71 à travers l'encoche 35, on connecte le câble de connexion 71 à la carte 9 ;
- on rompt la ligne de faiblesse délimitant l'encoche fusible 26 du socle 2 ;
- on remonte la façade 3 sur le socle 2, le module M étant provisoirement maintenu sur la façade 3, tout en prenant soin de faire passer le câble de connexion 71 à travers l'encoche fusible 26 ;
- on visse des vis de fixation V (de préférence du type vis inviolable) de la façade 3 sur le socle 2 et du module M sur le boîtier 1.

Un fois le module M monté sur et connecté au lecteur L, le module M et le lecteur L forment ensemble un système de contrôle d'accès S qui présente les fonctionnalités de contrôle du lecteur L et les fonctionnalités de contrôle du module M, avec une prise en gestion automatique de toutes ces fonctionnalités par le contrôleur de la carte électronique 9.

Il est également envisageable de prévoir, avant l'étape de remontage de la façade, une étape de fixation d'une plaque rigide arrière (par exemple métallique) sur le socle 2 et/ou sur le support, cette plaque venant dans la continuité de la paroi principale 20 du socle 2 afin de renforcer la rigidité globale du système de contrôle d'accès S.

## Revendications

1. Lecteur (L) de contrôle d'accès, du type comprenant :
- un boîtier (1) pourvu d'un socle (2) présentant une paroi principale (20) prévue pour une fixation sur un support et d'au moins une façade (3) montée sur ledit socle (2), la ou chaque façade (3) comprenant une paroi frontale (30) qui fait face à la paroi principale du socle (2) dans une configuration fermée du boîtier (1) de sorte que, une fois la façade (3) montée sur le socle (2), ledit boîtier (1) délimite intérieurement un espace clos ; et
- une carte électronique (9) disposée à l'intérieur dudit espace clos dans le boîtier (1) et intégrant au moins un contrôleur, une mémoire et un dispositif principal de contrôle d'accès, ledit contrôleur pilotant ledit dispositif principal de contrôle d'accès par la mise en oeuvre d'un premier algorithme de pilotage chargé dans la mémoire ;
ledit lecteur (L) étant **caractérisé en ce que** le boîtier (1) comporte :
- des moyens de fixation d'un module (M) complémentaire de contrôle d'accès, lesdits moyens de fixation étant configurés pour une fixation dudit module (M) sur l'extérieur du boîtier (1) ; et
- des moyens de passage d'un câble de connexion (71) entre ledit module (M) et un connecteur monté sur ladite carte électronique (9), lesdits moyens de passage comprenant une ligne de faiblesse formant une amorce de rupture d'une encoche fusible (26) ;
**et en ce que** la mémoire de la carte électronique (9) est chargée d'un deuxième algorithme de pilotage pour piloter ledit module (M) afin que le contrôleur pilote ledit module (M) une fois que ledit câble de connexion (71) est branché sur ledit connecteur.

2. Lecteur (L) selon la revendication 1, dans lequel les moyens de fixation comportent :
- des orifices de fixation (33) prévus sur le socle (2) et sur la ou chaque façade (3) pour le passage de vis de fixation ; et
- des moyens de maintien provisoire et d'indexage du module (M) sur le boîtier (1).

3. Lecteur (L) selon la revendication 2, dans lequel les moyens de maintien provisoire et d'indexage comprennent :
- un rebord inférieur (25) du socle (2) faisant saillie de la paroi principale (20) ; et
- un rebord inférieur (32) de la ou chaque façade (3) faisant saillie de la paroi frontale (30) où, dans la configuration fermée du boîtier (1), le rebord inférieur (32) de la façade (3) vient dans l'alignement du rebord inférieur (25) du socle (2) avec un écartement (EC) donné entre les deux rebords inférieurs (25, 32) pour former une fente inférieure sous le boîtier (1), afin de permettre le passage et l'indexage de pattes de maintien (51) du module (M).

4. Lecteur (L) selon la revendication 3, dans lequel la ligne de faiblesse est ménagée sur le rebord inférieur (25) du socle (2) pour former l'amorce de rupture d'une encoche fusible (26).

5. Lecteur (L) selon les revendications 3 ou 4, dans lequel la ou chaque façade (3) comporte en outre un plateau inférieur (34) en saillie de la paroi frontale (30) et disposé au-dessus du rebord inférieur (32) où, dans la configuration fermée du boîtier (1), ledit plateau (34) vient en appui contre le rebord inférieur (25) du socle (2), et les moyens de passage comprennent également une encoche (35) ménagée dans ledit plateau (34) et qui est, dans la configuration fermée du boîtier (1), positionnée en face de l'encoche fusible (26) prévue sur le rebord inférieur (25) du socle (2).

6. Lecteur (L) selon la revendication 5, dans lequel le rebord inférieur (25) du socle (2) est incliné vers le bas par rapport à la paroi principale (20) selon un angle non droit et, dans la configuration fermée du boîtier (1), le plateau (34) de la façade (3) est orthogonal à la paroi principale (20) du socle (2).

7. Lecteur (L) selon l'une quelconque des revendications précédentes, dans lequel le boîtier (1) du lecteur (L) comprend au moins une autre façade (3) interchangeable avec la façade (3) du boîtier (1), ladite autre façade (3) étant équipée d'un dispositif secondaire de contrôle d'accès, notamment du type contrôle clavier (C) ou contrôle écran (E), et où la mémoire de la carte électronique (9) est chargée d'un troisième algorithme de pilotage pour piloter ledit dispositif secondaire de contrôle d'accès afin que le contrôleur pilote ledit dispositif secondaire de contrôle d'accès une fois que l'autre façade (3) a remplacée la façade (3) sur le boîtier (1) et que le dispositif secondaire de contrôle d'accès est connecté à la carte électronique (9).

8. Lecteur (L) selon l'une quelconque des revendications précédentes, dans lequel la ou chaque façade (3) comporte des moyens d'encliquetage adaptés pour une fixation par encliquetage de la carte électronique (9).

9. Lecteur (L) selon la revendication 8, dans lequel les moyens d'encliquetage comprennent des butées d'appui (36) pour la carte électronique (9) et des pattes élastiquement déformables (37) équipées respectivement de dents d'encliquetage, avec éventuellement des crochets fixes (38) de retenue.

10. Système de contrôle d'accès comprenant un lecteur (L) conforme à l'une quelconque des revendications 1 à 9 et un module (M) complémentaire de contrôle adapté pour être fixé et connecté audit lecteur (L), ledit module (M) comprenant :
- un boîtier (4) équipé de moyens complémentaires de fixation conformés pour coopérer avec les moyens de fixation du boîtier (1) du lecteur (L) ; et
- un dispositif complémentaire de contrôle d'accès (7) disposé dans ledit boîtier (4) et raccordé à un câble de connexion (71) sortant dudit boîtier (4) et conformé pour traverser les moyens de passage prévus sur le boîtier (1) du lecteur (L), ledit câble de connexion (71) présentant une extrémité libre pourvue d'un connecteur complémentaire (72) conformé pour être branché sur le connecteur de la carte électronique (9) du lecteur (L) ;
où le boîtier (4) du module (M) est fixé sur l'extérieur du boîtier (1) du lecteur (L) et le dispositif complémentaire de contrôle d'accès (7) est connecté à la carte électronique (9) du lecteur (L) au moyen du câble de connexion (71) traversant l'encoche fusible (26) des moyens de passage prévus sur le boîtier (1) du lecteur (L).

11. Système de contrôle d'accès selon la revendication 10, dans lequel le lecteur (L) est conforme à la revendication 2 et les moyens complémentaires de fixation du module (M) comprennent :
- des orifices (60) ménagés sur le module (M) et adaptés pour coïncider avec les orifices de fixation (33) du lecteur (L), afin de permettre la fixation conjuguée du module (M) sur le boîtier (1) et de la façade (3) sur le socle (2) avec les mêmes vis de fixation (V) ; et
- des moyens complémentaires de maintien provisoire et d'indexage conformés pour coopérer avec les moyens de maintien provisoire et d'indexage du lecteur (L).

12. Système de contrôle d'accès selon la revendication 11, dans lequel le lecteur (L) est conforme à la revendication 3 et les moyens complémentaires de maintien provisoire et d'indexage du module (M) comportent des pattes de maintien (51) provisoire adaptées pour s'engager à travers la fente inférieure prévue sous le boîtier (1) du lecteur (L) et venir en appui sur le rebord inférieur (32) de la façade (3).

13. Système de contrôle d'accès selon l'une quelconque des revendications 10 à 12, dans lequel le module (M) est un module complémentaire de contrôle biométrique ou de contrôle clavier, où ledit dispositif complémentaire de contrôle d'accès (7) est du type contrôle biométrique ou contrôle clavier.

## Patentansprüche

1. Zugangskontrolllesegerät (L) des Typs, umfassend:
- ein Gehäuse (1), versehen mit einem Sockel (2), aufweisend eine Hauptwand (20), die für eine Befestigung auf einem Träger vorgesehen ist, und mit mindestens einer Fassade (3), die auf dem Sockel (2) angebracht ist, wobei die oder jede Fassade (3) eine Frontwand (30) umfasst, die der Hauptwand des Sockels (2) in einer geschlossenen Konfiguration des Gehäuses (1) derart gegenüberliegt, dass, sobald die Fassade (3) auf dem Sockel (2) angebracht ist, das Gehäuse (1) innen einen geschlossenen Raum begrenzt; und
- eine elektronische Karte (9), die im Inneren des geschlossenen Raums in dem Gehäuse (1) angeordnet ist und mindestens einen Controller, einen Speicher und eine Zugangskontrollhauptvorrichtung integriert, wobei der Controller die Zugangskontrollhauptvorrichtung durch die Durchführung eines ersten Steueralgorithmus steuert, der in dem Speicher geladen ist;
wobei das Lesegerät (L) **dadurch gekennzeichnet ist, dass** das Gehäuse (1) aufweist:
- Befestigungsmittel eines komplementären Zugangskontrollmoduls (M), wobei die Befestigungsmittel für eine Befestigung des Moduls (M) außen auf dem Gehäuse (1) konfiguriert sind; und
- Durchgangsmittel eines Verbindungskabels (71) zwischen dem Modul (M) und einem Verbinder, der auf der elektronischen Karte (9) angebracht ist, wobei die Durchgangsmittel eine Schwächungslinie umfassen, die einen Sollbruch einer Sicherungskerbe (26) bilden;
und dadurch, dass der Speicher der elektronischen Karte (9) mit einem zweiten Steueralgorithmus geladen ist, um das Modul (M) zu steuern, damit der Controller das Modul (M) steuert, sobald das Verbindungskabel (71) am Verbinder angeschlossen ist.

2. Lesegerät (L) nach Anspruch 1, wobei die Befestigungsmittel aufweisen:
- Befestigungsöffnungen (33), die auf dem Sockel (2) und auf der oder jeder Fassade (3) für den Durchgang von Befestigungsschrauben vorgesehen sind; und
- provisorische Halte- und Indexierungsmittel des Moduls (M) auf dem Gehäuse (1).

3. Lesegerät (L) nach Anspruch 2, wobei die provisorischen Halte- und Indexierungsmittel umfassen:
- eine untere Kante (25) des Sockels (2), die von der Hauptwand (20) absteht; und
- eine untere Kante (32) der oder jeder Fassade (3), die von der Frontwand (30) absteht, wobei in der geschlossenen Konfiguration des Gehäuses (1) die untere Kante (32) der Fassade (3) mit der unteren Kante (25) des Sockels (2) mit einer bestimmten Beabstandung (EC) zwischen den zwei unteren Kanten (25, 32) fluchtet, um einen unteren Schlitz unter dem Gehäuse (1) zu bilden, um den Durchgang und die Indexierung von Haltefüßen (51) des Moduls (M) zu erlauben.

4. Lesegerät (L) nach Anspruch 3, wobei die Schwächungslinie auf der unteren Kante (25) des Sockels (2) ausgeführt ist, um einen Sollbruch einer Sicherungskerbe (26) bilden.

5. Lesegerät (L) nach den Ansprüchen 3 oder 4, wobei die oder jede Fassade (3) ferner ein unteres Plateau (34) aufweist, das von der Frontwand (30) absteht und oberhalb der unteren Kante (32) angeordnet ist, wobei sich in der geschlossenen Konfiguration des Gehäuses (1) das Plateau (34) auf der unteren Kante (25) des Sockels (2) abstützt, und die Durchgangsmittel ebenfalls eine Kerbe (35) umfassen, die in dem Plateau (34) ausgeführt ist und die in der geschlossenen Konfiguration des Gehäuses (1) gegenüber der Sicherungskerbe (26) positioniert ist, die auf der unteren Kante (25) des Sockels (2) vorgesehen ist.

6. Lesegerät (L) nach Anspruch 5, wobei die untere Kante (25) des Sockels (2) in Bezug auf die Hauptwand (20) in einem nicht rechten Winkel nach unten geneigt ist und in der geschlossenen Konfiguration des Gehäuses (1) das Plateau (34) der Fassade (3) orthogonal zu der Hauptwand (20) des Sockels (2) ist.

7. Lesegerät (L) nach einem der vorangehenden Ansprüche, wobei das Gehäuse (1) des Lesegeräts (L) mindestens eine andere Fassade (3) aufweist, die mit der Fassade (3) des Gehäuses (1) austauschbar ist, wobei die andere Fassade (3) mit einer sekundären Zugangskontrollvorrichtung ausgestattet ist, insbesondere vom Typ Tastaturkontrolle (C) oder Bildschirmkontrolle (E), und wobei der Speicher der elektronischen Karte (9) mit einem dritten Steueralgorithmus geladen ist, um die sekundäre Zugangskontrollvorrichtung zu steuern, damit der Controller die sekundäre Zugangskontrollvorrichtung steuert, sobald die andere Fassade (3) die Fassade (3) auf dem Gehäuse (1) ersetzt hat und die sekundäre Zugangskontrollvorrichtung mit der elektronischen Karte (9) verbunden ist.

8. Lesegerät (L) nach einem der vorangehenden Ansprüche, wobei die oder jede Fassade (3) Rastmittel aufweist, die für eine Befestigung durch Rasten der elektronischen Karte (9) geeignet sind.

9. Lesegerät (L) nach Anspruch 8, wobei die Rastmittel Stützanschläge (36) für die elektronische Karte (9) und elastisch verformbare Füße (37) aufweisen, die jeweils mit Rastzähnen ausgestattet sind, mit eventuell festen Haltehaken (38).

10. Zugangskontrollsystem, umfassend ein Lesegerät (L) nach einem der Ansprüche 1 bis 9 und ein komplementäres Kontrollmodul (M), das für die Befestigung an und die Verbindung mit dem Lesegerät (L) geeignet ist, wobei das Modul (M) umfasst:
- ein Gehäuse (4), ausgestattet mit komplementären Befestigungsmitteln, die ausgebildet sind, um mit den Befestigungsmitteln des Gehäuses (1) des Lesegeräts (L) zusammenzuwirken; und
- eine komplementäre Zugangskontrollvorrichtung (7), die in dem Gehäuse (4) angeordnet und an ein Verbindungskabel (71) angeschlossen ist, das aus dem Gehäuse (4) austritt und ausgebildet ist, um die Durchgangsmittel zu durchqueren, die auf dem Gehäuse (1) des Lesegeräts (L) vorgesehen sind, wobei das Verbindungskabel (71) ein freies Ende aufweist, das mit einem komplementären Verbinder (72) versehen ist, der ausgebildet ist, um an dem Verbinder der elektronischen Karte (9) des Lesegeräts (L) angeschlossen zu sein;
wobei das Gehäuse (4) des Moduls (M) außen auf dem Gehäuse (1) des Lesegeräts (L) befestigt ist und die komplementäre Zugangskontrollvorrichtung (7) mit der elektronischen Karte (9) des Lesegeräts (L) mittels des Verbindungskabels (71) verbunden ist, das die Sicherungskerbe (26) der Durchgangsmittel durchquert, die auf dem Gehäuse (1) des Lesegeräts (L) vorgesehen sind.

11. Zugangskontrollsystem nach Anspruch 10, wobei das Lesegerät (L) nach Anspruch 2 ausgebildet ist und die komplementären Befestigungsmittel (M) umfassen:
- Öffnungen (60), die auf dem Modul (M) ausgeführt sind und geeignet, um mit den Befestigungsöffnungen (33) des Lesegeräts (L) übereinzustimmen, um die vereinte Befestigung des Moduls (M) auf dem Gehäuse (1) und der Fassade (3) auf dem Sockel (2) mit denselben Befestigungsschrauben (V) zu erlauben; und
- komplementäre provisorische Halte- und Indexierungsmittel, die ausgebildet sind, um mit den provisorischen Halte- und Indexierungsmitteln des Lesegeräts (L) zusammenzuwirken.

12. Zugangskontrollsystem nach Anspruch 11, wobei das Lesegerät (L) nach Anspruch 3 ausgebildet ist und die komplementären provisorischen Halte-und Indexierungsmittel des Moduls (M) provisorische Haltefüße (51) aufweisen, die für den Eingriff durch den unteren Schlitz, der unter dem Gehäuse (1) des Lesegeräts (L) vorgesehen ist, geeignet sind, und sich auf der unteren Kante (32) der Fassade (3) abzustützen.

13. Zugangskontrollsystem nach einem der Ansprüche 10 bis 12, wobei das Modul (M) ein komplementäres Modul zur biometrischen Kontrolle oder Tastaturkontrolle ist, wobei die komplementäre Zugangskontrollvorrichtung (7) vom Typ biometrische Kontrolle oder Tastaturkontrolle ist.

## Claims

1. An access control reader (L), of the type comprising:
- a casing (1) provided with a base (2) having a main wall (20) provided to be fastened to a support and at least a facade (3) mounted on said base (2), the or each facade (3) comprising a front wall (30) which is facing the main wall of the base (2) in a closed configuration of the casing (1) so that, once the facade (3) mounted on the base (2), said casing (1) internally delimits an enclosed space ; and
- an electronic board (9) disposed inside said enclosed space in the casing (1) and integrating at least one controller, a memory and a main access control device, said controller driving said main access control device by the implementation of a first driving algorithm loaded in the memory;
said access control reader (L) being **characterized in that** the casing (1) includes :
- fastening means for fastening a complementary access control module (M), said fastening means being configured for attachment of said module (M) on the outside of the casing (1); and
- passage means for passing of a connection cable (71) between said module (M) and a connector mounted on said electronic board (9), said passage means comprising a line of weakness forming an incipient crack of a fuse notch (26); **and in that** the memory of the electronic board (9) is loaded with a second driving algorithm to drive said module (M) so that the controller drives said module (M) once said connection cable (71) is plugged onto said connector.

2. The access control reader (L) according to claim 1, wherein the fastening means include:
- fastening holes (33) provided on the base (2) and on the or each facade (3) for the passage of fastening screws; and
- temporary holding and indexing means of the module (M) on the casing (1).

3. The access control reader (L) according to claim 2, wherein the temporary holding and indexing means comprise:
- a lower edge (25) of the base (2) protruding from the main wall (20); and
- a lower edge (32) of the or each facade (3) protruding from the front wall (30) where, in the closed configuration of the casing (1), the lower edge (32) of the facade (3) is in alignment with the lower edge (25) of the base (2) with a given spacing (EC) between the two lower edges (25, 32) to form a lower slot under the casing (1), in order to allow the passage and the indexing of holding legs (51) of the module (M).

4. The access control reader (L) according to claim 3, wherein the line of weakness is arranged on the lower edge (25) of the base (2) to form the incipient crack of a fuse notch (26).

5. The access control reader (L) according to claim 3 or 4, wherein the or each facade (3) further includes a lower plate (34) protruding from the front wall (30) and disposed above the lower edge (32) where, in the closed configuration of the casing (1), said plate (34) bears against the lower edge (25) of the base (2), and the passage means also comprise a notch (35) arranged in said plate (34) and which is, in the closed configuration of the casing (1), positioned opposite the fuse notch (26) provided on the lower edge (25) of the base (2).

6. The access control reader (L) according to claim 5, wherein the lower edge (25) of the base (2) is tilted downward relative to the main wall (20) at a non-right angle and, in the closed configuration of the casing (1), the plate (34) of the facade (3) is orthogonal to the main wall (20) of the base (2).

7. The access control reader (L) according to any one of the preceding claims, wherein the casing (1) of the reader (L) comprises at least one other facade (3) interchangeable with the facade (3) of the casing (1), said other facade (3) being equipped with a secondary access control device, in particular of the keyboard control (C) or screen control (E) type, and where the memory of the electronic board (9) is loaded with a third driving algorithm to drive said secondary access control device so that the controller drives said secondary access control device, once the other facade (3) has replaced the facade (3) on the casing (1) and the secondary access control device is connected to the electronic board (9).

8. The access control reader (L) according to any one of the preceding claims, wherein the or each facade (3) includes snap-fit means adapted for a snap-fit fastening of the electronic board (9).

9. The access control reader (L) according to claim 8, wherein the snap-fit means comprise bearing stops (36) for the electronic board (9) and elastically deformable legs (37) equipped respectively with snap-fit teeth, possibly with fixed retaining hooks (38).

10. An access control system comprising a reader (L) according to any one of the claims 1 to 9 and a complementary control module (M) adapted to be fastened and connected to said reader (L), said module (M) comprising:
- a casing (4) equipped with complementary fastening means shaped to cooperate with the fastening means of the casing (1) of the access control reader (L); and
- a complementary access control device (7) disposed in said casing (4) and joined to a connection cable (71) outgoing from said casing (4) and shaped to pass through the passage means provided on the casing (1) of the access control reader (L), said connection cable (71) having a free end provided with a complementary connector (72) shaped to be plugged onto the connector of the electronic board (9) of the reader (L);
wherein the casing (4) of the module (M) is fixed on the outside of the casing (1) of the reader (L) and the complementary access control device (7) is connected to the electronic card (9) of the reader (L) by means of the connection cable (71) passing through the fuse notch (26) of the passage means provided on the casing (1) of the reader (L).

11. The access control system according to claim 10, wherein the reader (L) is according to claim 2 and the complementary fastening means of the module (M) comprise:
- holes (60) arranged on the module (M) and adapted to match with the fastening holes (33) of the access control reader (L), in order to allow the mating fastening of the module (M) on the casing (1) and of the facade (3) on the base (2) with the same fastening screws (V); and
- complementary temporary holding and indexing means shaped to cooperate with the temporary holding and indexing means of the access control reader (L).

12. The access control system according to claim 11, wherein the reader (L) is according to claim 3 and the temporary holding and indexing means of the module (M) include holding legs (51) adapted to be engaged through the lower slot provided under the casing (1) of the access control reader (L) and to bear on the lower edge (32) of the facade (3).

13. The access control system according to any one of the claims 10 to 12, wherein the module (M) is a complementary biometric control module or a complementary keyboard control module, and the complementary access control device (7) is of the biometric control or keyboard control type.
